# EUROPÄISCHE PATENTSCHRIFT

(11) **EP 0 571 790 B1**
(45) Veröffentlichungstag und Bekanntmachung des Hinweises auf die Patenterteilung: **17.02.1999**
(21) Anmeldenummer: 93107330.8
(22) Anmeldetag: 06.05.1993
(51) Int. Cl.: H04N 5/52, H04N 5/50, H03G 3/20

(54) **Fernsehempfänger mit mikrocomputergesteuerter Verstärkungsregelung**
Television receiver with a gain control actuated by a microcomputer
Récepteur de télévision avec un contrôle de gain commandé par un microordinateur

(30) Priorität: 23.05.1992 DE 4217190
(43) Veröffentlichungstag der Anmeldung: 01.12.1993
(73) Patentinhaber: GRUNDIG Aktiengesellschaft, 90762 Fürth (DE)
(72) Erfinder: Knauer, Thomas, GRUNDIG E.M.V., W-8510 Fürth/Bay (DE); Meisel, Siegfried, GRUNDIG E.M.V., W-8510 Fürth/Bay (DE); Rehak, Manfred, GRUNDIG E.M.V., W-8510 Fürth/Bay (DE); Ronsenberger, Winfried, Dipl.-Ing., GRUNDIG E.M.V., W-8510 Fürth/Bay (DE)

(56) Entgegenhaltungen:
- EP-A- 0 453 937
- DE-A- 3 346 678
- DE-A- 4 011 650
- DE-A- 4 038 110
- PATENT ABSTRACTS OF JAPAN vol. 11, no. 376 (E-563)(2823) 8. Dezember 1987 & JP-A-62 143 572 ( VICTOR CO OF JAPAN LTD ) 26. Juni 1987

## Beschreibung

Die Erfindung betrifft einen Fernsehempfänger mit den im Oberbegriff des Anspruchs 1 angegebenen Merkmalen.

Aus dem Buch "Fernsehtechnik ohne Ballast" (Limann/Pelka), 16. Auflage, 1991, Franzis-Verlag GmbH, München, S. 75/76, S. 94-99 und S. 202-204, ist es bereits bekannt, in einem Fernsehempfänger eine automatische Verstärkungsregelung durchzuführen. Mittels einer derartigen automatischen Verstärkungsregelung können unterschiedliche Antennenspannungen der Sender ausgeglichen, Übersteuerungen der nach dem Fernsehtuner angeordneten Stufen vermieden, die gegenseitige Beeinflussung benachbarter Stationen verringert und eine gleichbleibende Aussteuerung der Bildröhre erreicht werden. Die zur automatischen Verstärkungsregelung benötigte analoge Regelspannung wird am Ausgang des ZF-Verstärkers aus den Synchronimpulsen des Fernsehsignals gewonnen.

Weiterhin ist aus der DE-C2-33 46 678 eine Anordnung zur Steuerung des Regeleinsatzes für die Verstärkungsregelung in einem Rundfunkempfänger bekannt. Bei dieser bekannten Anordnung wird die Ansprechschwelle eines in einem integrierten ZF-Baustein ohnehin vorhandenen Schwellwertschalters kanal- oder kanalgruppenabhängig variiert. Dazu werden während des Tunerabgleichs im Anschluß an die Fertigung die für die einzelnen Frequenzkanäle ermittelbaren Verstärkungswerte des Tuners digital codiert und in einem nichtflüchtigen Speicher kanalbezogen abgelegt. Mittels dieser abgespeicherten Verstärkungswerte kann der Regeleinsatz der Verstärkungsregelung durch eine kanalabhängige Einstellung der Ansprechschwelle so gesteuert werden, daß der Tuner auch bandintern für alle Kanäle bei den gleichen oder annähernd gleichen maximal zulässigen Signaleingangspegeln abgeregelt wird.

Aus der DE-A-36 09 349 ist eine Fernsehabstimmvorrichtung bekannt, bei der eine Gleichlaufeinstellung erfolgt. Dabei werden die abstimmbaren Elemente in den Abstimmkreisen des Tuners unter Verwendung eines Hilfscomputers im Sinne einer Veränderung der Resonanzfrequenzen der Abstimmkreise angesteuert. Bei dieser schrittweise erfolgenden Gleichlaufeinstellung wird nach jedem Schritt überprüft, ob sich der Hochfrequenzverstärker des Tuners im Sättigungszustand befindet oder nicht. Ist das der Fall, dann wird seine Verstärkung verringert. Diese Einstellung der Verstärkung des Hochfrequenzverstärkers unter Verwendung des Hilfscomputers erfolgt ausschließlich im Rahmen der Gleichlaufeinstellung. Ist diese abgeschlossen, dann erfolgt eine analoge automatische Verstärkungsregelung.

Aus der englischsprachigen Zusammenfassung der JP-A-63-50274 ist eine automatische Verstärkungsregelung bekannt, bei der eine digitale Signalverarbeitung verwendet wird. Die bekannte Anordnung weist einen Amplitudendetektor auf, in welchem die Amplitude des Synchronsignals mit einem Referenzwert verglichen wird. Der dabei erhaltene Differenzwert wird im eingeschwungenen Zustand des Systems über einen Schalter einem Digital-/Analog-Wandler zugeführt und in Form eines analogen Verstärkungsregelsignals dem Steuereingang eines Verstärkers zugeführt.

Weiterhin ist aus der DE-A-30 10 242 ein Fernsehempfänger mit Übersteuerungsschutz bekannt. Bei diesem Fernsehempfänger erfolgt unter anderem auch eine automatische Regelung der HF- und der ZF-Verstärkung. Dabei wird zunächst die ZF-AVR aktiviert und erst danach die HF-AVR in Betrieb genommen. Zusätzlich ist ein Übersteuerungsdetektor vorgesehen, der bei Vorliegen eines Übersteuerungszustandes, wie er beispielsweise dann auftreten kann, wenn bei einer Kanalumschaltung plötzlich ein starker Sender gefunden wird, die HF-AVR unmittelbar steuert. Diese bekannte AVR-Regelung erfolgt rein analog.

Aus DE 40 11 650 A1 ist eine Regelschaltung für eine elekronisch einstellbare Vorstufe eines Überlagerungsempfängers bekannt, wobei im Signalweg wenigstens zwei Pegelmesser vorgesehen sind. Ein Mikroprozessor steuert ein am Eingang vorgesehenes Dämpfungsglied derart, daß sich ein günstiges Nutzsignal/Störverhältnis ergibt. Der Mikroprozessor vergleicht die gemessenen analog/digital gewandelten Pegel mit Speicherwerten aus einem Speicher und steuert über einen Digital/Analog-Wandler die Dämpfung des Dämpfungsgliedes.

Der Erfindung liegt die Aufgabe zugrunde, einen Empfänger der eingangs genannten Art anzugeben, bei dem die Eingangsverstärkung des Tuners auf einfache Weise geräteindividuell insbesondere bei der Fertigung abgeglichen werden kann und der auch im Betrieb eine hohe Eingangsstörfestigkeit aufweist. Darüberhinaus soll eine möglichst universelle Auswertung des den Mikroprozessor ansteuernden digitalen Regelsignals für verschiedene Anwendungsmöglichkeiten angebeben werden.

Diese Aufgabe wird durch die im kennzeichnenden Teil des Anspruchs 1 angegebenen Merkmale gelöst.

Vorteilhafte Ausgestaltungen der Erfindung sind in den Unteransprüchen enthalten.

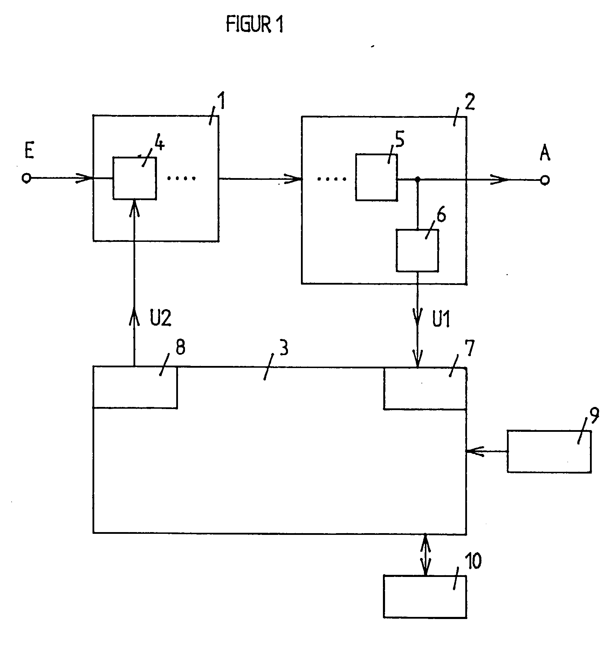

Im folgenden wird die Erfindung anhand der Figur 1 näher erläutert, welche die zum Verständnis der Erfindung nötigen Bestandteile eines Fernsehempfängers zeigt.

Dem Eingang E wird das von der Empfangsantenne abgeleitete hochfrequente Fernsehsignal zugeführt. Dieses wird in einem Tuner 1 zunächst an einen Eingangsverstärker 4 angelegt, dessen Verstärkung mittels einer Regelspannung U2 steuerbar ist, und dann in herkömmlicher Weise weiterverarbeitet. Das Ausgangssignal des Tuners 1 gelangt an einen ZF-Baustein 2, in welchem es über einen nicht gezeichneten regelbaren Verstärker einem Demodulator 5 zugeführt wird. Dort wird es in ein Basisband- bzw. FBAS-Signal umgesetzt, welches am Ausgang A zur Verfügung steht.

Das genannte FBAS-Signal wird weiterhin einer Schaltung 6 zugeführt, in der eine erste analoge Regelspannung U1 für eine automatische Verstärkungsregelung erzeugt wird. Dies geschieht bei Vorliegen von Signalen mit negativer Bildmodulation (beispielseise Fernsehnormen B und G) durch Auswertung der Amplitude der Synchronimpulse und bei Vorliegen von Signalen mit positiver Bildmodulation (beispielsweise Fernsehnorm L) durch Auswertung des Weißpegels des Signals.

Die erhaltene erste analoge Regelspannung U1 wird dem Regeleingang des nicht gezeichneten, dem Demodulator 5 vorgeschalteten regelbaren Verstärkers zugeführt. Weiterhin wird sie in einem Analog/Digital-Wandler 7 in ein digitales Regelsignal umgewandelt und in einem Mikrocomputer 3 mit einem digitalen Referenzsignal verglichen, welches dem Mikrocomputer 3 aus einem nichtflüchtigen Speicher 9 zugeführt wird. Der Mikrocomputer 3 leitet in Abhängigkeit vom erhaltenen Vergleichsergebnis eine digitale Steuerspannung ab. Diese wird in einem Digital/Analog-Wandler 8 in eine zweite analoge Regelspannung U2 umgewandelt, welche zur Steuerung des Verstärkungsfaktors des Eingangsverstärkers 4 des Tuners 1 verwendet wird.

Das im nichtflüchtigen Speicher 9 abgespeicherte digitale Referenzsignal wird im Anschluß an die Fertigung des Fernsehempfängers im Werk ermittelt. Dazu wird ein Signal definierten Pegels an den Eingang E des Tuners 1 angelegt. Dieser definierte Pegel entspricht demjenigen Pegel, bei welchem im späteren Gerätebetrieb die Tunerregelung einsetzen soll. Weiterhin erzeugt der Mikrocomputer 3 die Regelspannung U2 derart, daß der maximale Verstärkungsfaktor des Eingangsverstärkers 4 des Tuners 1 eingestellt ist. Danach wird die sich am Ausgang der Schaltung 6 einstellende erste analoge Regelspannung U1 im Analog/Digital-Wandler 7 in ein digitales Regelsignal umgewandelt, welches als digitales Referenzsignal in den nichtflüchtigen Speicher 9 übernommen wird.

Bei einer ersten bevorzugten Ausführungsform der Erfindung erfolgt die Abspeicherung des genannten digitalen Referenzsignals für alle Kanäle gemeinsam, d.h. es wird nur ein einziges digitales Referenzsignal abgespeichert, welches allen Kanälen gemeinsam ist. Der Vorteil dieser Ausführungsform besteht insbesondere darin, daß der im Werk anfallende Zeitaufwand für die Ermittlung des digitalen Referenzsignals gering ist.

Bei einer zweiten bevorzugten Ausführungsform der Erfindung wird für jeden Kanal ein eigenes digitales Referenzsignal im nichtflüchtigen Speicher 9 abgespeichert. Dies erfordert zwar mehr Zeitaufwand im Werk, hat aber den Vorteil, daß im späteren Gerätebetrieb für jeden einzelnen Kanal ein optimales Referenzsignal zur Verfügung steht. Damit kann beispielsweise dem Umstand Rechnung getragen werden, daß der Tuner in den verschiedenen Kanälen unterschiedliche Verstärkungseigenschaften aufweist.

Den beiden vorgenannten Ausführungsformen ist weiterhin der Vorteil gemeinsam, daß der bisher in der Fertigung übliche manuelle Abgleich des Eingangsverstärkers 4 des Tuners 1 entfallen kann.

Im späteren Gerätebetrieb wird - wie bereits oben beschrieben - die am Ausgang der Schaltung 6 zur Verfügung stehende erste analoge Regelspannung U1 nach Analog/Digital-Wandlung im Mikrocomputer mit dem abgespeicherten digitalen Referenzsignal verglichen und in Abhängigkeit vom Vergleichsergebnis eine zweite analoge Regelspannung U2 erzeugt, welche zur Steuerung des Verstärkungsfaktors des Eingangsverstärkers 4 des Tuners 1 verwendet wird. Steigt beispielsweise im Gerätebetrieb der Pegel des am Eingang E anliegenden hochfrequenten Fernsehsignals an, dann erhöht sich auch der Pegel der ersten analogen Regelspannung U1. Der Mikrocomputer 3 erkennt dies und verringert die zweite Regelspannung U2 solange, bis die von der Schaltung 6 gelieferte erste Regelspannung U1 (nach Analog/Digital-Wandlung) mit dem abgespeicherten digitalen Referenzsignal übereinstimmt. Fällt hingegen im Gerätebetrieb der Pegel des am Eingang E anliegenden hochfrequenten Fernsehsignals ab, dann verringert sich auch der Pegel der ersten analogen Regelspannung U1. Der Mikrocomputer erkennt dies und erhöht die zweite Regelspannung U2 solange, bis die von der Schaltung 6 gelieferte erste Regelspannung U1 (nach Analog/Digital-Wandlung) mit dem abgespeicherten digitalen Referenzsignal übereinstimmt. Ein Vorteil der vorstehend beschriebenen Verstärkungsregelung besteht in der sehr hohen Regelsteilkeit, die zu einer hohen Eingangsstörfertigkeit führt.

Im folgenden werden verschiedene Anwendungsmöglichkeiten der Erfindung näher beschrieben.

Eine erste ist die Verwendung des Fernsehempfängers als Multistandardgerät, welches Fernsehsignale mit negativer und Fernsehsignale mit positiver Bildmodulation verarbeiten kann.

Bei Fernsehsignalen mit negativer Bildmodulation erfolgt die Ermittlung der ersten analogen Regelspannung U1 durch Auswertung der Amplitude der Synchronimpulse. Diese stehen in jeder Zeile des Fernsehsignals zur Verfügung, so daß eine Regelung mit einer vergleichsweise kleinen Regelzeitkonstante erfolgen kann.

Bei Fernsehsignalen mit positiver Bildmodulation, wie sie beispielsweise bei der in Frankreich verwendeten Fernsehnorm L vorliegen, erfolgt die Ermittlung der ersten analogen Regelspannung U1 durch Auswertung des Weißpegels. Um eine derartige Regelung zu ermöglichen, wird von den Fernsehsendern sichergestellt, daß in jedem Halbbild für ein bestimmtes Zeitintervall der Weißpegel zur Verfügung steht. Manche Sender senden aus diesem Grund für die Dauer einer Zeile der vertikalen Austastlücke den Weißpegel, andere lediglich für die Dauer von 10 µs. Demnach muß die automatische Verstärkungsregelung für Fernsehsignale mit positiver Bildmodulation eine vergleichsweise große Regelzeitkonstante aufweisen.

Diese Bedingungen können gemäß der Erfindung durch eine geeignete Programmierung des Mikrocomputers 3 sichergestellt werden. Die Aktivierung der jeweils gewünschten Zeitkonstante erfolgt bei der Anwahl des jeweiligen Senders unter Verwendung eines Normkennbits, welches zusammen mit den Abstimmdaten in einem der zugehörigen Kanalwahltaste zugeordneten Speicher abgelegt ist.

Weiterhin kann die Erfindung verwendet werden, um den Einfluß von kurzzeitigen, auf Störsignale zurückgehenden Spannungsschwankungen im ersten analogen Regelsignal U1 auf das zweite analoge Regelsignal U2 zu beseitigen. Dazu werden im Mikrocomputer 3 erst mehrere Vergleichsvorgänge durchgeführt und ausgewertet, um einzelne störungsbedingte Veränderungen im ersten analogen Regelsignal U1 zu erkennen. Der Regelvorgang wird erst dann in Gang gesetzt, wenn mehrere aufeinanderfolgende Vergleichsvorgänge auf eine Änderung des HF-Pegels am Eingang E des Tuners hinweisen.

Eine weitere Anwendungsmöglichkeit der Erfindung besteht in einer programmplatzbezogenen Abspeicherung der digitalen Steuerspannung in einem weiteren nichtflüchtigen Speicher 10. Diese programmplatzbezogenen digitalen Steuerspannungen werden bei der ersten Inbetriebnahme bzw. dem Abstimmvorgang (Kanalprogrammierung) bei Betätigung der Speichertaste zusammen mit den Abstimmdaten für den jeweiligen Programmplatz abgespeichert und entsprechen der vom Mikrocomputer 3 ermittelten digitalen Steuerspannung, die für den momentan eingestellten Sender charakteristisch ist. Da aufgrund des Umstandes, daß die verschiedenen Sender verschiedene Sendeleistungen und unterschiedliche Entfernungen zum Empfangsort haben, unterschiedlich hohe Spannungen am Eingang E des Tuners anliegen, sind diese digitalen Steuerspannungen unterschiedlich. Der Vorteil der Abspeicherung programmplatzbezogener digitaler Steuerspannungen besteht darin, daß nach der Anwahl eines Programmplatzes die jeweils zugehörige digitale Steuerspannung im Speicher 10 zur Verfügung steht, so daß die Verstärkung des Eingangsverstärkers 4 des Tuners 1 - ohne daß es eines Einregel- bzw. Einschwingvorganges bedarf - optimal und verzögerungsfrei eingestellt werden kann.

Eine weitere Anwendungsmöglichkeit der Erfindung besteht beim Suchlaufvorgang. Bei bekannten Geräten muß sich die Verstärkungsregelung nach dem Auffinden eines starken Sender erst einmal entladen, was Zeit benötigt. In dieser Zeit kann ein benachbarter schwacher Sender in unerwünschter Weise überlaufen werden. Um dieses zu vermeiden, wird erfindungsgemäß das zweite analoge Verstärkungsregelsignal U2 sofort nach Betätigung der Suchlauftaste vom Mikrocomputer 3 auf seinen Maximalwert gestellt, d.h. der Tuner 1 auf seine maximale Verstärkung gesetzt, so daß auch schwache Sender, die starken Sendern benachbart übertragen werden, nicht überlaufen werden.

Weiterhin kann die Erfindung verwendet werden, um dem Benutzer beim Ausrichten der Antenne eines tragbaren Fernsehempfängers (Portables) Informationen über den am Eingang E anliegenen HF-Pegel zu geben. Dazu verwendet der Mikrocomputer 3 das ihm zugeführte Regelsignal zur Erzeugung eines Balkens, welcher auf dem Bildschirm des Fernsehempfängers dargestellt wird. Die Länge des Balkens ist ein Maß für die Amplitude des Regelsignals und damit auch für die Eingangsspannung des Tuners und damit wiederum für die Ausrichtung der Antenne.

Schließlich kann die Erfindung bei der Selbstprogrammierung eines Fernsehempfängers verwendet werden. Bei dieser Selbstprogrammierung, die vom Mikrocomputer 3 des Fernsehempfängers gesteuert wird, durchläuft der Tuner 1 des Fernsehempfängers alle Fernsehkanäle und speichert die Abstimmdaten aller empfangbaren Sender ab. Erfindungsgemäß sortiert der Mikrocomputer 3 alle empfangbaren Sender unter Verwendung des ihm zugeführten Regelsignals U1, welches gleichzeitig ein Maß für die Empfangsfeldstärke des jeweiligen Sender ist. Weiterhin identifiziert der Mikrocomputer alle Sender, die Videotext oder VPS-Signale ausstrahlen, anhand der darin enthaltenen Kennungen und sortiert bei gleichen Sendern, die mit unterschiedlichen Empfangsfeldstärken empfangen werden , den bzw. die schwächeren aus, so daß bei der Selbstprogrammierung bei Empfang von gleichen Sendern in verschiedenen Empfangskanälen nur der stärkste übernommen wird.

## Patentansprüche

1. Empfänger mit einer regelbaren Eingangsstufe (1, 4), mit einer Schaltung (6) zur Erzeugung eines ersten analogen Verstärkungsregelsignals (U1), mit einem Analog/Digital-Wandler (7) zur Umwandlung des ersten analogen Verstärkungsregelsignals (U1) in ein digitales Regelsignal, mit einem ersten nichtflüchtigen Speicher (9) zur Abspeicherung mindestens eines digitalen Referenzsignals, mit einem Mikrocomputer (3) zum Vergleich des digitalen Regelsignals mit dem digitalen Referenzsignal zur Ableitung einer digitalen Steuerspannung in Abhängigkeit des erhaltenen Vergleichsergebnisses, mit einem Digital/Analog-Wandler (8) zur Umwandlung der digitalen Steuerspannung in ein zweites analoges Verstärkungsregelsignal (U2), welches einem Steuereingang der regelbaren Eingangsstufe (1, 4) zugeführt wird,
**dadurch gekennzeichnet,**
- daß der Empfänger ein Fernsehempfänger ist, daß die Eingangsstufe (1, 4) einen Tuner (1) mit einem Eingangsverstärker (4) aufweist und daß der nichtflüchtige Speicher (9) ein digitales Referenzsignal enthält, das dem digitalen Regelsignal entspricht, das sich bei einem auf seinen Maximalwert gestellten Verstärkungsfaktor des Eingangsverstärkers (4) bei einem am Eingang des Eingangsverstärkers (4) anliegenden Signal definierten Pegels, insbesondere des Pegels, bei dem die Regelung des Tuners (1) einsetzen soll, ergibt,
- daß der Mikrocomputer (3) bei Betätigung der Suchlauftaste der Bedieneinheit des Fernsehempfängers das zweite analoge Verstärkungsregelsignal derart erzeugt, daß es seinen Maximalwert hat und
- daß der Mikrocomputer (3) das digitale Regelsignal als Maß für die Empfangsfeldstärke von empfangbaren Sendern auswertet, wobei der Mikrokomputer (3) bei der Selbstprogrammierung empfang bare Sender unter Verwendung des ihm zugeführten digitalen Regelsignals als Maß für die Empfangsfeldstärke sortiert.

2. Empfänger nach Anspruch 1,
**dadurch gekennzeichnet,**
daß der Mikrocomputer (3) zur Steuerung einer Selbstprogrammierung des Fernsehempfängers und zur Identifizierung der Sender anhand von Kennungen vorgesehen ist.

3. Empfänger nach einem der Ansprüche 1 oder 2,
**dadurch gekennzeichnet,**
daß der Mikrocomputer (3) das digitale Regelsignal als Maß für die Empfangsfeldstärke von empfangbaren Sendern auswertet,
wobei von gleichen Sendern, die mit unterschiedlichen Empfangsfeldstärken empfangen werden, nur der Sender mit der größten Empfangsfeldstärke übernommen wird und/oder
wobei der Mikrocomputer (3) die Anzeige eines dem analogen Regelsignal(U1) entsprechenden Maßes zur Information über den am Eingang anliegenden HF-Pegel, insbesondere eines Balkens auf dem Bildschirm des Fernsehempfängers auslöst und/oder
wobei der Mikrocomputer (3) bei der Selbstprogrammierung des Fernsehempfängers das ihm zugeführte erste analoge Regelsignal (U1) zur Sortierung der empfangbaren Sender nach ihrer Empfangsqualität verwendet.

4. Empfänger nach einem der Ansprüche 1 bis 3,
**dadurch gekennzeichnet,**
daß die Regelzeitkonstante für die Verstärkungsregelung bei Empfang von Fernsehsignalen mit positiver Bildmodulation größer ist als bei Empfang von Fernsehsignalen mit negativer Bildmodulation.

5. Empfänger nach einem der Ansprüche 1 bis 4,
**dadurch gekennzeichnet,**
daß die Aktivierung der gewünschten Regelzeitkonstante unter Verwendung eines abgespeicherten Normkennbits erfolgt.

6. Empfänger nach einem der Ansprüche 1 bis 5,
**dadurch gekennzeichnet,**
daß der Mikrocomputer (3) zur Beseitigung eines Einflusses von kurzzeitigen, auf Störsignale zurückgehenden Spannungsschwankungen im ersten analogen Verstärkungsregelsignal (U1) auf das zweite analoge Verstärkungsregelsignal (U2) mehrere Vergleichsvorgänge durchführt und auswertet, wobei ein Regelvorgang erst dann in Gang gesetzt wird, wenn mehrere aufeinanderfolgende Vergleichsvorgänge auf eine Änderung des HF-Pegels am Eingang des Tuners (1) hinweisen.

7. Empfänger nach einem der Ansprüche 1 bis 6,
**dadurch gekennzeichnet,**
daß der Fernsehempfänger einen weiteren nichtflüchtigen Speicher (10) zur Abspeicherung von programmplatzbezogenen digitalen Steuerspannungen enthält und der Mikrocomputer (3) bei Anwahl eines Programmplatzes die zugehörige Steuerspannung über den Digital/Analog-Wandler (8) an den Regeleingang des Eingangsverstärkers (4) des Tuners (1) anlegt.

8. Empfänger nach Anspruch 7,
**dadurch gekennzeichnet,**
daß der weitere nichtflüchtige Speicher (10) zu Abspeicherung der programmplatzbezogenen digitalen Steuerspannungen beim Abstimmvorgang des Fernsehempfängers vorgesehen ist.

9. Empfänger nach einem der Ansprüche 1 bis 8,
**dadurch gekennzeichnet,**
daß ein für alle Fernsehkanäle gemeinsames digitales Referenzsignal im nichtflüchtigen Speicher ( 9 ) oder daß für jeden Fernsehkanal ein eigenes digitales Referenzsignal im nichtflüchtigen Speicher (9) vorgesehen ist.

10. Empfänger nach einem der Ansprüche 1 bis 9,
**dadurch gekennzeichnet,**
daß das Fernsehgerät ein Multistandardgerät ist, das insbesondere zur Verarbeitung von Fernsehsignalen mit negativer und positiver Bildmodulation vorgesehen ist, daß der Mikrocomputer (3) zur Aktivierung einer jeweils unterschiedlichen Regelzeitkonstanten bei Fernsehsignalen mit unterschiedlichem Standard vorgesehen ist.

## Claims

1. A receiver with a controllable input stage (1, 4), a circuit (6) for generating a first analogue gain control signal (U1), an analogue-digital converter (7) for converting the first analogue gain control signal (U1) into a digital control signal, a first non-volatile memory (9) for storing at least one digital reference signal, a microcomputer (3) for comparing the digital control signal with the digital reference signal to derive a digital control voltage as a function of the comparison result obtained, a digital-analogue converter (8) for converting the digital control voltage into a second analogue gain control signal (U2) which is fed to a control input of the controllable input stage (1, 4), characterised in that
- the receiver is a television receiver, the input stage (1, 4) comprises a tuner (1) with an input amplifier (4), and the non-volatile memory (9) contains a digital reference signal which corresponds to the digital control signal which occurs in the case of a gain factor of the input amplifier (4) set at its maximum value upon the occurrence of a signal at the input of the input amplifier (4) with a defined level, in particular the level at which the adjustment of the tuner (1) is to commence,
- upon the actuation of the search button of the operating unit of the television receiver, the microcomputer (3) generates the second analogue gain control signal in such manner that it has its maximum value and
- the microcomputer (3) evaluates the digital control signal as a gauge of the reception field strength of receivable transmitters and during the automatic programming the microcomputer (3) sorts receivable transmitters using the digital control signal, with which it is supplied, as a gauge of the reception field strength.

2. A receiver according to Claim 1, characterised in that the microcomputer (3) is provided for controlling an automatic programming of the television receiver and for identifying the transmitters on the basis of codes.

3. A receiver according to one of Claims 1 or 2, characterised in that the microcomputer (3) evaluates the digital control signal as a gauge of the reception field strength of receivable transmitters wherein, of identical transmitters received with different reception field strengths, only the transmitter with the greatest reception field strength is accepted and/or wherein the microcomputer (3) triggers the display of a gauge, corresponding to the analogue control signal (U1), indicating the HF level present at the input, in particular a bar, on the screen of the television receiver, and/or wherein in the automatic programming of the television receiver the microcomputer (3) uses the first analogue control signal (U1), with which it is supplied, to sort the receivable transmitters in terms of their reception quality.

4. A receiver according to one of Claims 1 to 3, characterised in that the control time constant for the gain control is greater in the case of the reception of television signals with positive vision modulation than in the case of the reception of television signals with negative vision modulation.

5. A receiver according to one of Claims 1 to 4, characterised in that the desired control time constant is activated using a stored standard marker bit.

6. A receiver according to one of Claims 1 to 5, characterised in that to eliminate an influence upon the second analogue gain control signal (U2) of short-duration voltage fluctuations in the first analogue gain control signal (U1) caused by interference signals, the microcomputer (3) performs and evaluates a plurality of comparison processes, where a control process commences only when a plurality of consecutive comparison processes point to a change in the HF level at the input of the tuner (1).

7. A receiver according to one of Claims 1 to 6, characterised in that the television receiver contains a further non-volatile memory (10) for the storage of program-position-related digital control voltages and upon the selection of a program position the microcomputer (3) applies the associated control voltage via the digital-analogue converter (8) to the control input of the input amplifier (4) of the tuner (1).

8. A receiver according to Claim 7, characterised in that the further non-volatile memory (10) is provided for storing the program-position-related digital control voltages in the tuning process of the television receiver.

9. A receiver according to one of Claims 1 to 8, characterised in that a digital reference signal common to all the television channels is provided in the non-volatile memory (9) or a separate digital reference signal for each television channel is provided in the non-volatile memory (9).

10. A receiver according to one of Claims 1 to 9, characterised in that the television device is a multistandard device provided in particular for the processing of television signals with negative and positive vision modulation, and that the microcomputer (3) is provided in each case to activate a different control time constant in the case of television signals with a different standard.

## Revendications

1. Récepteur comportant un étage d'entrée réglable (1, 4), comprenant un circuit (6) pour produire un premier signal analogique de régulation d'amplification (U1), un convertisseur analogique/numérique (7) pour convertir le premier signal analogique de régulation d'amplification (U1) en un signal de régulation numérique, une première mémoire non volatile (9) pour mémoriser au moins un signal de référence numérique, un micro-ordinateur (3) pour comparer le signal de régulation numérique au signal de référence numérique pour dériver une tension de commande numérique en fonction du résultat de comparaison obtenu, un convertisseur numérique/analogique (8) pour convertir la tension de commande numérique en un second signal analogique de régulation d'amplification (U2), qui est envoyé à une unité de commande de l'étage d'entrée réglable (1, 4),
caractérisé en ce
- le récepteur est un récepteur de télévision, que l'étage d'entrée (1, 4) comporte un tuner (1) comportant un amplificateur d'entrée (4) et que la mémoire non volatile (9) contient un signal de référence numérique, qui correspond au signal de régulation numérique que l'on obtient pour un facteur d'amplification réglé à sa valeur maximale, de l'amplificateur d'entrée (4) dans le cas d'un signal appliqué à l'entrée de l'amplificateur d'entrée (4) et possédant un niveau défini, notamment le niveau, pour lequel la régulation du tuner (1) doit être exécutée,
- que, lors de l'actionnement de la touche de recherche de l'unité de commande du récepteur de télévision, le micro-ordinateur (3) produit le second signal analogique de régulation d'amplification de telle sorte qu'il possède sa valeur maximale, et
- que le micro-ordinateur (3) évalue le signal de régulation numérique en tant que valeur pour l'intensité du champ de réception d'émetteurs pouvant être reçus, auquel cas, lors de la programmation automatique, le micro-ordinateur (3) sélectionne des émetteurs pouvant être reçus en utilisant le signal de régulation numérique, qui lui est envoyé, en tant que mesure de l'intensité du champ de réception.

2. Récepteur selon la revendication 1, caractérisé en ce que le micro-ordinateur (3) est prévu pour la commande d'une programmation automatique du récepteur de télévision et pour l'identification des émetteurs sur la base d'indicatifs.

3. Récepteur selon l'une des revendications 1 ou 2,
caractérisé en ce
que le micro-ordinateur (3) évalue le signal de régulation numérique en tant que mesure de l'intensité de champ de réception d'émetteurs pouvant être reçus,
auquel cas parmi des émetteurs identiques, qui sont reçus avec des intensités de champ de réception différentes, seul l'émetteur ayant l'intensité de champ de réception maximale est pris en charge et/ou
que le micro-ordinateur (3) déclenche l'affichage d'une valeur, qui correspond au signal analogique de régulation (U1) à titre d'information concernant le niveau HF présent à l'entrée, notamment une barre sur l'écran du récepteur de télévision et/ou
lors de la programmation automatique du récepteur de télévision, le micro-ordinateur (3) utilise le premier signal de régulation analogique (U1), qui lui est envoyé, pour effectuer une sélection parmi les émetteurs pouvant être reçus, en fonction de leur qualité de réception;

4. Récepteur selon l'une des revendications 1 à 3,
caractérisé en ce
que la constante de temps de régulation pour la régulation d'amplification lors de la réception de signaux de télévision avec une modulation d'image positive est plus élevée que dans le cas de la réception de signaux de télévision avec une modulation d'image négative.

5. Récepteur selon l'une des revendications 1 à 4,
caractérisé en ce que l'activation de la constante de temps de régulation désirée s'effectue moyennant l'utilisation d'un bit caractéristique normalisé mémorisé.

6. Récepteur selon l'une des revendications 1 à 5,
caractérisé en ce
que pour l'élimination d'une influence de variations de tension de brève durée, imputables à des signaux parasites, dans le premier signal analogique de régulation d'amplification (U1), sur le second signal analogique de régulation d'amplification (U2), le micro-ordinateur (3) exécute et évalue plusieurs processus de comparaison, un processus de régulation étant mis en oeuvre uniquement lorsque plusieurs processus de comparaison successifs indiquent une variation du niveau HF à l'entrée du tuner (1).

7. Récepteur selon l'une des revendications 1 à 6,
caractérisé en ce
que le récepteur de télévision contient une autre mémoire non volatile (10) pour la mémorisation de tensions numériques de commande rapportées à un emplacement de programme, et que lors de la sélection d'un emplacement de programme, le micro-ordinateur (3) applique la tension de commande associée, par l'intermédiaire du convertisseur numérique/analogique (8), à l'entrée de régulation de l'amplificateur d'entrée (4) du tuner (1).

8. Récepteur selon la revendication 7, caractérisé en ce que l'autre mémoire non volatile (10) est prévue pour la mémorisation des tensions de commande numériques rapportées à un emplacement de programme, lors de la procédure de réglage d'accord du récepteur de télévision.

9. Récepteur selon l'une des revendications 1 à 8,
caractérisé en ce qu'un signal de référence numérique commun pour tous les canaux de télévision est prévu dans la mémoire non volatile (9) ou que, pour chaque canal de télévision, un signal de référence numérique particulier est prévu dans la mémoire non volatile (9).

10. Récepteur selon l'une des revendications 1 à 9,
caractérisé en ce que l'appareil de télévision est un appareil à standards multiples, qui est prévu notamment pour le traitement de signaux de télévision ayant une modulation d'image positive et une modulation d'image négative et que le micro-ordinateur (3) est prévu pour activer des constantes de temps de régulation respectives différentes dans le cas de signaux de télévision ayant des standards différents.
